(19)

**Europäisches Patentamt**
**European Patent Office**
**Office européen des brevets**

(11)  **EP 4 110 950 B1**

(12) **EUROPEAN PATENT SPECIFICATION**

(45) Date of publication and mention
of the grant of the patent:
**26.11.2025  Bulletin 2025/48**

(51) International Patent Classification (IPC):
**C12Q 1/686** *(2018.01)*      **B01J 19/08** *(2006.01)*
**B01J 19/12** *(2006.01)*

(21) Application number: **21761818.0**

(22) Date of filing: **24.02.2021**

(52) Cooperative Patent Classification (CPC):
**B01L 7/52; B01J 19/12; B01J 19/128;**
B01L 2200/147; B01L 2300/0832; B01L 2300/1861;
B01L 2300/1872

(86) International application number:
**PCT/US2021/019498**

(87) International publication number:
**WO 2021/173736 (02.09.2021 Gazette 2021/35)**

(54) **METHODS FOR CONTINUOUS MONITORING, SYNTHESIS, AND DETECTION OF BIOCHEMISTRY**

VERFAHREN ZUR KONTINUIERLICHEN ÜBERWACHUNG, SYNTHESE UND DETEKTION VON BIOCHEMIE

PROCÉDÉS DE SURVEILLANCE, DE SYNTHÈSE ET DE DÉTECTION EN CONTINU DE BIOCHIMIE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **24.02.2020  US 202062980636 P**

(43) Date of publication of application:
**04.01.2023  Bulletin 2023/01**

(73) Proprietor: **California Institute of Technology
Pasadena, CA 91125 (US)**

(72) Inventor: **RAJAGOPAL, Aditya
Pasadena, CA 91125 (US)**

(74) Representative: **Barker Brettell LLP
100 Hagley Road
Edgbaston
Birmingham B16 8QQ (GB)**

(56) References cited:
WO-A1-2008/140754      WO-A1-2014/140596
WO-A1-2016/115542      US-A1- 2005 202 185
US-A1- 2008 131 939      US-A1- 2009 294 692
US-A1- 2014 170 664

- JUN HO SON, BYUNGRAE CHO, SOONGWEON HONG, SANG HUN LEE, ORI HOXHA, AMANDA J HAACK, LUKE P LEE: "Ultrafast photonic PCR", LIGHT: SCIENCE & APPLICATIONS, NATURE PUBLISHING GROUP, UK, vol. 4, no. 7, 1 July 2015 (2015-07-01), UK, pages e280 - 7, XP055278281, ISSN: 2047-7538, DOI: 10.1038/lsa.2015.53
- SON JUN HO, HONG SOONGWEON, HAACK AMANDA J., GUSTAFSON LARS, SONG MINSUN, HOXHA ORI, LEE LUKE P.: "Rapid Optical Cavity PCR", ADVANCED HEALTHCARE MATERIALS, WILEY - V C H VERLAG GMBH & CO. KGAA, DE, vol. 5, no. 1, 1 January 2016 (2016-01-01), DE, pages 167 - 174, XP055840181, ISSN: 2192-2640, DOI: 10.1002/adhm.201500708

EP 4 110 950 B1

## Description

## BACKGROUND

The majority of synthetic chemistry is performed as a series of discrete reactions that are allowed to equilibrate. Only a small number of conditions may be manipulated that affect equilibration of a chemical reaction, including the concentration of reagents and reactants, and temperature. Both temperature and reagent/reactant concentrations affect the diffusion time, the mean-free-path, and correlation time of the reaction complex. However, temperature alone regulates the average kinetic energy of, and hence the activation energy available to the chemical reaction. Achieving the necessary temperature for a chemical synthesis reaction without inputting more energy than is required is still an issue for today's technologies.

For example, Polymerase Chain Reaction, or "PCR" is a method of exponential amplification of specific nucleic acid target in a reaction mix with a nucleic acid polymerase and primers. A standard PCR reaction is modulated by successive temperature cycling, which either promotes or inhibits the formation of a double-stranded nucleic acid segment. The reaction is usually regulated through contact joule-heating and convection cooling. Transitions between temperature points take a long time due to the thermal mass of the reaction chamber and the heat source. As such, the reaction is often allowed more than sufficient time to equilibrate at each temperature step. The technologies described herein optimize temperature regulation in a way that allows for less input energy for a given chemical synthesis reaction, and thus improves the overall signal to noise ratio of the reaction. US 2005/202185 A1 relates to localized heating of micro or nanostructures and their associated methods of use and applications. US2009/294692 discloses a method and a system for producing a change in a medium disposed in an artificial container.

## SUMMARY

The technology disclosed herein is directed to methods and systems for regulating and continuously monitoring a chemical synthesis reaction. The invention is defined by claim 1.

In some examples, the method also includes measuring a background illumination using a photodiode matched to the electro-magnetic radiation source. In some examples, the characteristic of the metal micro-object may include one or more shape, metal, and permittivity. The shape of the metal micro-object may be sphere, a rod, a cylinder, or a cube. In some examples, the metal micro-object may be between about 100nm to about $10\mu$m in diameter. In some examples, the electro-magnetic radiation may be infrared radiation. More than one micro-object may be added to the reaction mixture. In some examples, the metal micro-object may made of gold, silver, titanium, nickel, steel, tin, platinum, copper, aluminum, lead, or iron. In some examples, the electro-magnetic radiation source may include a laser diode. The reaction mixture may include one or more of buffers, reagents, a thermostable polymerase, and deoxyribonucleotide triphosphates.

In examples, a method for regulating a chemical synthesis reaction may include introducing a metal micro-object to a reaction mixture, determining a plasmon resonance of the metal micro-object based on a characteristic of the metal micro-object, and applying with an electro-magnetic radiation source, electro-magnetic radiation to the reaction mixture. In examples, the reaction mixture may include a biological sample, amplification oligomers, deoxyribonucleotide triphosphates, and a thermostable polymerase. The electromagnetic radiation may be wavelength-matched to a plasmon resonance of the metal micro-object, such that application of the electro-magnetic radiation to the metal micro-object excites atoms within the metal micro-object, causing those atoms to release energy in the form of phonons within the reaction mixture thereby increasing an average kinetic energy of the reaction mixture.

In some examples, the biological sample may include genomic DNA. The reaction mixture may also include a detection probe. In examples, the detection probe may include a fluorescent label. In some examples, the implication oligomers may include a forward implication oligomer and a reverse amplification oligomer.

In examples, a system for regulating a chemical synthesis reaction is provided. For example, a system for regulating a chemical synthesis reaction may include an electro-magnetic radiation source, a receiving unit containing a reaction mixture comprising a metal micro-object, and a computer component programmed to apply, with an electromagnetic radiation source, electro-magnetic radiation to the reaction mixture. The electro-magnetic radiation is wavelength-matched to the plasmon resonance of the metal micro-object such that application of the electro-magnetic radiation to the metal micro-object excites atoms within the metal micro-object, causing those atoms to release energy in the form of phonons within the reaction mixture thereby increasing an average kinetic energy of the reaction mixture.

In embodiments, a kit for regulating a chemical synthesis reaction is provided. For example, a kit for regulating a chemical synthesis reaction may include an electro-magnetic radiation source, a metal micro-object, amplification oligomers, deoxyribonucleotide triphosphates, a thermostable polymerase, and a capillary tube. In some embodiments, the kit may include one or more metal micro-objects. In some embodiments, the metal micro-object is a gold microsphere. In some embodiments, the amplification oligomers may include a forward amplification oligomer and a reverse amplification oligomer. In some examples, the kit may include detection probes.

## BRIEF DESCRIPTION OF THE DRAWINGS

The technology disclosed herein, in accordance with one or more various embodiments, is described in detail with reference to the following figures. The drawings are provided for purposes of illustration only and merely depict typical or example embodiments of the disclosed technology. These drawings are provided to facilitate the reader's understanding of the disclosed technology and shall not be considered limiting of the breadth, scope, or applicability thereof. It should be noted that for clarity and ease of illustration these drawings are not necessarily made to scale.

  FIG. 1 is an operational flow diagram illustrating an example method for regulating a chemical synthesis reaction using an electro-magnetic radiation source in accordance with implementations of the disclosure.

  FIG. 2 illustrates by way of example, reaction chemistries using micro-objects in accordance with various embodiments disclosed herein.

  FIG. 3 illustrates by way of example, real-time monitoring of a chemical synthesis reaction in accordance with various embodiments disclosed herein.

  FIG. 4 illustrates by way of a diagram, a system for regulating and monitoring a chemical synthesis reaction may be used in accordance with implementations of the disclosure.

  FIG. 5 illustrates a computer component that can be utilized in implementing architectures and methods, in accordance with various implementations of the disclosure.

The figures are not intended to be exhaustive or to limit the invention to the precise form disclosed. It should be understood that the invention can be practiced with modification and alteration, and that the disclosed technology be limited only by the claims and the equivalents thereof.

## DETAILED DESCRIPTION

The following description provides specific details for a comprehensive understanding of, and enabling description for, various embodiments of the technology. It is intended that the terminology used be interpreted in its broadest reasonable manner, even where it is being used in conjunction with a detailed description of certain embodiments.

The technology disclosed herein is directed to methods and systems for regulating and continuously monitoring chemical synthesis reactions using monodispersed micro-objects fabricated from conductive materials and electro-magnetic radiation. Conductive materials, such as metals, exhibit collective electronic resonances or oscillations that are incompressible and irrotational. These collective electronic resonances are known as plasmons. Plasmons generated in microscopic metals (e.g., metals smaller than a wavelength of light) can be directly excited by applying electro-magnetic radiation, which oscillates the electrons within the electron cloud. As excited plasmons decay, they can release energy in the form of phonons and vibrations. In some embodiments disclosed herein, this release of energy is harnessed to modulate a chemical synthesis reaction.

Provided herein are methods for regulating and continuously monitoring a chemical synthesis reaction. In certain embodiments, the methods described herein may be applied in the context of a PCR assay to better modulate the synthesis rate of the reaction. For example, in embodiments, monodispersed micro-objects may be added to a reaction mixture. Electro-magnetic radiation, including for example, infrared radiation, that is wavelength-matched to the plasmon resonance of the micro-object may then be applied to reaction mixture through an electro-magnetic radiation source, which causes decay of the plasmon. As the plasmon decays, the release of energy increases the average kinetic energy of the reaction mixture. This process may be reversed by limiting the amount of radiation applied. In some embodiments, the reaction may monitored by measuring the background illumination at the electro-magnetic radiation source using, for example, photodiodes or other photo-transducers. In embodiments, other optical reporting molecules, such as fluorophores may be used to continuously monitor the synthesis reaction in real-time.

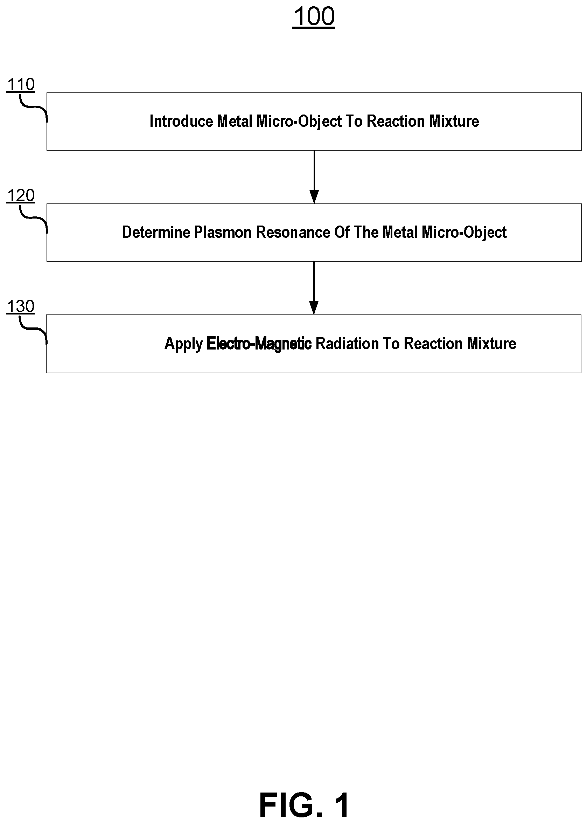

FIG. 1 is a flow diagram illustrating an example method for regulating a chemical synthesis reaction using electro-magnetic radiation. At a high level, method 100 may be performed to regulate the rate of a chemical synthesis reaction in accordance with various embodiments of the disclosure. In some embodiments, method 100 provides a means for controlling the rate of a chemical synthesis reaction, such as a PCR assay, using monodispersed micro-objects and an electro-magnetic radiation source that applies electro-magnetic radiation to the reaction mixture. In some embodiments, the electro-magnetic radiation is generated in infrared wavelengths (*i.e.,* wavelengths between approximately 760 nm to 100,000 nm). In some embodiments, method 100 also allows for the continuous monitoring of a chemical synthesis reaction. The operations of the various methods described herein are not necessarily limited to the order described or shown in the figures, and one of skill in the art will appreciate, upon studying the present disclosure, variations of the order of the operations described herein that are within the spirit and scope of the disclosure. In some embodiments, the operations of method 100 may be repeated multiple times.

At operation 110, a micro-object is introduced to a reaction mixture. In embodiments, more than one micro-object may be introduced to the reaction mixture. The micro-object may be made of a conductive material. In some examples, the conductive material is a metal. In some embodiments, the micro-object may be fabricated from gold, silver, platinum, steel, tin, zinc, tungsten, mercury, indium, aluminum, titanium, copper, nickel, palladium, beryllium, lead, iron, other conductive materials, or mixtures thereof. In embodiments, the micro-object may be formed into a variety of shapes depending on the application. For example, the micro-object may be formed into a sphere and/or a substantially spherical shape. In some examples, the micro-object may be formed as a cylinder, ellipsoid ovaloid, rod, prism, cube, or polygonoid, or other three-dimensional shape. The dimensions of the micro-objects may also vary depending on the shape of the micro-object, the wavelength of electro-magnetic energy being used to excite the plasmons on the micro-object, and/or the application for which it is used. For example, the dimensions of a micro-object that is shaped in a sphere may range from about 100nm to about 10$\mu$m in diameter. In some examples, the micro-object that is shaped to form a rod may have dimensions of about 100nm to about 10$\mu$m in length, about 100nm to about 10$\mu$m in width, and/or about 100nm to about 10$\mu$m in height. In some embodiments, the micro-objects introduced to the reaction mixture are uniform (i.e., are the same size and shape). In some embodiments, the micro-objects introduced to the reaction mixture are non-uniform and thus vary in their size and shape. In embodiments, the micro-objects are added to the reaction mixture and may be dispersed uniformly throughout the reaction mixture. In some embodiments, the micro-objects are dispersed in a non-uniform manner throughout the reaction mixture.

In some embodiments, method 100 may be performed to regulate a chemical synthesis reaction. In some embodiments, a chemical synthesis reaction may take place in a reaction mixture, which itself may include various biochemical elements, such as components necessary to amplify genomic DNA or RNA. For example, in some embodiments, a reaction mixture may include one or more of buffers, reagents, a thermostable polymerase, deoxyribonucleotide triphosphates, amplification oligomers or primers, and detection probes.

In some embodiments, a reaction mixture may include a biological sample. It is to be understood that the biological sample may include DNA and/or cDNA. The biological sample may be derived from more than one organism. In some embodiments, the biological sample may be derived from blood, sweat, urine, tears, or any other bodily secretion. Moreover, in some embodiments, the biological sample may be obtained from a human or from some other animal. In some embodiments, the biological sample may be digested prior to performing method 100.

In embodiments, once the reaction mixture is formed, the reaction mixture may be partitioned into reaction volumes (e.g., capillary tubes, wells, microwells, droplets, etc.). For example, in some embodiments, method 100 may be performed in a capillary tube, wherein the radius of the capillary tube may be smaller than the Debye length of the reaction mixture. In some embodiments, method 100 may be performed in a microwell. In some embodiments the reaction mixture may partitioned into a plurality of reaction volumes. In some embodiments, the reaction mixture may be partitioned into reaction volumes prior to introducing the micro-objects. In embodiments, the reaction mixture may be partitioned into reaction volumes and may then be subjected to PCR amplification. In some embodiments, more than one reaction volumes may be amplified simultaneously.

At operation 120, the plasmon resonance of the micro-object may be determined. In embodiments, the plasmon resonance of the micro-object may be determined based on one or more characteristics of the micro-object. Characteristics of the micro-object that may impact the micro-object's plasmon resonance include, for example, its shape, temperature, dimensions, material composition, and/or its permittivity. One or more of the characteristics may impact the selection of the incident wavelength applied to excite plasmons in the micro-object.

For example, the plasmon resonance frequency $\omega_{sp}$ in a metal micro-object may be explained by the following equation where $\omega_p$ is the bulk plasma frequency, $\varepsilon_b$ is the contribution of bound electrons in permittivity of metal, and $\varepsilon_m$ is the permittivity of the environment:

$$\omega_{sp} = \frac{\omega_p}{\sqrt{\varepsilon_b + 1 + 2\varepsilon_m}}$$

In embodiments, an increase in temperature may lead to a decrease in the bulk plasma frequency $\omega_p$. This may be the result of, for example, thermal expansion of the micro-object. For example, the volume of the micro-object depends on temperature as $V(T) = V_0(1 + \beta\Delta T)$, where $V_0$ is the volume of the micro-object at room temperature, $\Delta T = T - T_0$ is the temperature variation, and $\beta$ is the volume thermal expansion coefficient. In embodiments, the bulk plasma frequency of metal may be temperature dependent and expressed as the following equation where $\omega_{p0}$ = the square root of $(4\pi n_0 e^2/m^*)$ is the plasma frequency, $n_0$ is the concentration of free elections of the metal, $m^*$ is the effective electron mass, and $e$ is the election charge:

$$\omega_p(T) = \sqrt{\frac{4\pi n(T)e^2}{m^*}} = \frac{\omega_{p0}}{\sqrt{1 + \beta\Delta T}}$$

At operation 130, electro-magnetic radiation is directed (e.g.., pumped) to the reaction mixture, including one or more micro-objects. In some embodiments, the wavelength of the incident electro-magnetic radiation is selected to be infrared. In other embodiments, the wavelength of the incident radiation may be selected from microwave, visible, ultraviolet, X-ray, gamma ray, other wavelengths, or mixtures thereof selected to excite plasmons in conductive micro-objects and/or nano-objects. In embodiments, the radiation applied to the reaction mixture is wavelength-matched to the plasmon resonance of the micro-object. In some embodiments, the application of the electro-magnetic radiation to the micro-object excites the atoms within the micro-object causing those atoms to release energy in the form of phonons within the reaction mixture. In embodiments, the release of energy by the plasmon (*i.e.,* plasmon decay), increases the overall kinetic energy of the reaction mixture. In embodiments, the plasmon energy may be harnessed to regulate a chemical synthesis reaction. For example, application of wavelength-matched electro-magnetic radiation to the reaction mixture increases the temperature of the reaction mixture. Conversely, when the electro-magnetic radiation is withheld, the temperature of the reaction mixture may decrease. In embodiments, temperature increase may lead to an increase of the phonon population in the metal, which in turn, may lead to an increase rate of free electrons scattering on phonons. For example, temperature dependence of electron-photon scattering rate may be explained by the following equation where $T_0$ is temperature, $\theta$ is the Debye temperature for metal, and $S$ is the constant.

$$\gamma_{e-ph}(T) = S \left[ \frac{2}{5} + 4 \left( \frac{T}{\theta} \right)^5 \int_0^{\theta/T} \frac{x^4 dx}{e^x - 1} \right]$$

In some embodiments, operation 130 may be performed using an electro-magnetic radiation source, such as, for example, a laser diode. However, other types of diodes emitting other wavelengths of electro-magnetic radiation may also be used. In some embodiments, other semiconductor devices that convert electronical energy into light may also be used *(e.g.,* a light-emitting diode). In some embodiments, operation 130 may be performed using more than one laser diodes. In some embodiments, electro-magnetic radiation, for example infrared radiation, is applied to the reaction mixture by flickering an infrared laser diode that is wavelength-matched to the plasmon resonance of the micro-objects suspended in the reaction mixture. The decay in the plasmon resonance of these molecules is used to modulate the temperature of the reaction mixture. In embodiments, application of electro-magnetic radiation through flickering of a laser diode regulates the internal temperature of the reaction mixture.

In some embodiments, the electro-magnetic radiation, for example infrared radiation, is delivered to the micro-objects in the reaction mixture may be monitored by measuring a background illumination at the electro-magnetic radiation source using photodiodes or other photo-transducers matched to the same wavelength as the electro-magnetic radiation source. For example, one or more P/N photodiodes may be attached the electro-magnetic radiation source, or in proximity to the electro-magnetic radiation source, and may detect the electro-magnetic radiation reflected back from the reaction mixture and convert that electromagnetic radiation into an electrical current that may be measured. Such a measurement, for example, may be used as a feedback mechanism to regulate the temperature of the reaction mixture. In embodiments, both the electro-magnetic radiation source and measurement photodiodes may be fabricated to operate in excess of 10GHz. When method 100 is used in the context of PCR amplification, for example, the rate of operation for the electro-magnetic radiation source and measuring photodiodes is well above the rate needed for single-base extension control of the polymerase enzyme.

In some embodiments, method 100 may be performed to regulate and monitor a chemical synthesis reaction. For example, method 100 may be performed to regulate and monitor a PCR assay in order to amplify nucleic acids. Such a reaction mixture may include components necessary to amplify a nucleic acid including amplification oligomers (i.e., primers), thermostable polymerases, DNA or RNA template, deoxyribonucleotide triphosphates, detection probes, and one or more buffers and regents.

In some embodiments, a reaction mixture may include a set of amplification oligomers (i.e., a forward primer and a reverse primer) configured to amplify specific nucleic acid. The amplification oligomers may use specific sequences to amplify a specific sequence. The amplification oligomers may amplify a specific sequence by hybridizing to a sequence upstream and downstream of the primers and result in amplifying the sequence inclusively between the upstream and downstream primer. An amplification oligomer may be a forward primer. An amplification oligomer may be a reverse primer. An amplification oligomer may be between about 5 and about 50 nucleotides in length. An amplification oligomer may range between 5 and 50 base pairs in length. In some examples, an amplification oligomer may exceed 50 base pairs in length. In some examples, the amplification oligomers may be between 5-50 base pairs in length. In embodiments, the amplification oligomers may be about 5, 10, 11, 12, 13, 14, 15, 16, 17, 18, 19, 20, 25, 30, 35, 40, 45, or about 50 base pairs in length.

Different sets of amplification oligomers may be configured to amplify different nucleic acid target sequences. For example, a first set of amplification oligomers may be configured to amplify a first nucleic acid sequence of a given length, and a second set of amplification oligomers may be configured to amplify a second nucleic acid sequence of shorter length than the first nucleic acid sequence. In another example, a first set of amplification oligomers be configured to amplify a first nucleic acid sequence of a given length, and a second set of amplification oligomers may be configured to amplify a second nucleic acid sequence of longer length than the first nucleic acid sequence.

In some embodiments, the reaction mixture may include a thermostable polymerase, including for example, a DNA polymerase. Any suitable DNA polymerase may be used, including commercially available DNA polymerases. A thermostable polymerase generally refers to an enzyme that is capable of incorporating nucleotides to a strand of DNA in a template bound fashion. A thermostable polymerase may include Taq polymerase or a variant thereof.

In some embodiments, the reaction mixture may include the use of nucleotide tri-phosphate reagents. The nucleotide tri-phosphate reagents may include using deoxyribonucleotide tri-phosphate (dNTPs). dNTPs may include natural or non-natural dNTPs including, for example, dATP, dCTP, dGTP, dTTP, dUTP, and variants thereof. The nucleotide tri-phosphate reagents may be used as precursors to the amplified nucleic acids.

In some embodiments, the reaction mixture may include detection probes that may be configured to anneal to a specific region of nucleic acids. In some embodiments, the detection probes may include a molecular beacon, a molecular torch, and/or a detectable label. In some embodiments, a detectable label may include a chemiluminescent label. In some embodiments, a detectable label may be include a fluorescent label. In some embodiments the detection probes may include a quencher. In some embodiments, the detection probes may include commercially available detection probes including, for example, TaqMan probes.

In embodiments, the probes may be the same or may be different. A detection probe may range between 5 and 30 nucleotides in length. In some examples, the detection probe may exceed 30 nucleotides in length. In some examples, a mixture includes a first detection probe and one or more additional detection probes. A detection probe may range between 2 and 50 nucleotides in length, or more. In some examples, a detection probe may be 2, 3, 4, 5, 6, 7, 8, 9, 10, 20, 30, 40, or 50 nucleotides in length.

In some examples, 2, 3, 4, 5, 6, 7, 8, 9, 10, 11, 12, 13, 14, 15, 20, or more different detection probes may be used. Each detection probe may correspond to (*e.g.,* capable of binding to) a given region of a nucleic acid target *(e.g.,* a chromosome) in a biological sample. In one example, a first detection probe is specific for a first region of a first nucleic acid target, a second detection probe is specific for a second region of the first nucleic acid target. Each detection probe may include a signal tag with about equal emission wavelengths. In some examples, each detection probe includes an identical fluorophore. In some examples, each detection probe includes a different fluorophore. In some case, each fluorophore is capable of being detected in a single optical channel. In some examples, a fluorophore may be detected in multiple channels.

In some embodiments, the reaction mixture may include one or more reagents and/or buffers. Appropriate buffer conditions may, in some cases, be such that the appropriate salts are present in a buffer used during amplification. Appropriate salts may include magnesium salts, potassium salts, ammonium salts. Appropriate buffer conditions may be such that the appropriate salts are present in appropriate concentrations.

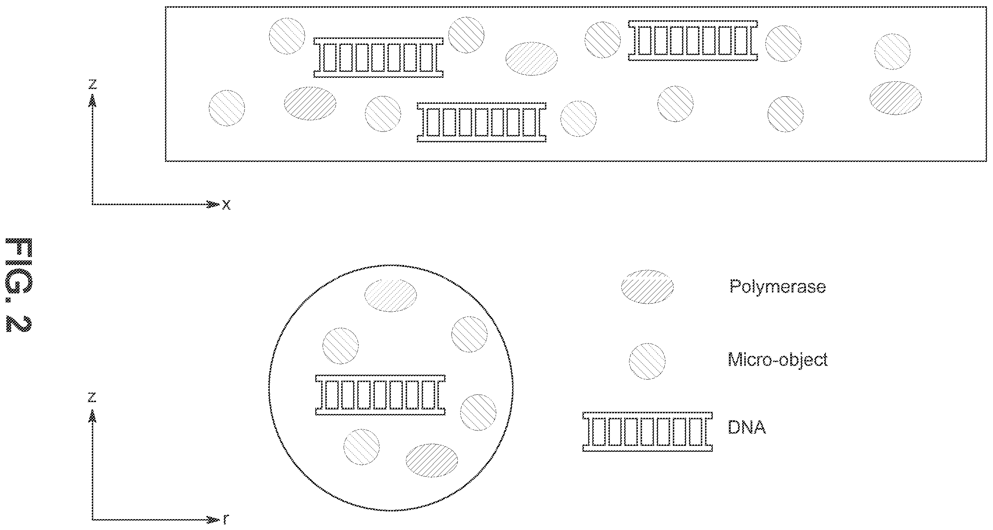

FIG. 2 illustrates by way of example, a chemical synthesis reaction using micro-objects and electro-magnetic radiation in accordance with various embodiments disclosed herein. For example, a reaction mixture may be prepared that includes template DNA or RNA, thermostable polymerase, primers, and one or more reagents, buffers, and nucleotides. In embodiments, one or more micro-objects may be introduced to the reaction mixture and interspersed uniformly throughout. The micro-object as shown in FIG. 2, by way of example, is a gold microsphere. It is to be appreciated, however, that the micro-object may be prepared using other metals and/or shapes. In embodiments, once the reaction mixture has been prepared, electro-magnetic radiation may then be applied to the reaction mixture. In the chemical synthesis reaction of FIG. 2, application of electro-magnetic radiation to the reaction mixture modulates the activity of a DNA polymerase. For example, by pumping the gold microspheres at their plasmon resonance, the decay of the plasmon releases energy in the form of phonons within the reaction mixture at a non-coherent frequency, and increases the overall average kinetic energy of the reaction. In this way, the reaction mixture may be thermally regulated and the DNA synthesis reaction may take place.

In some embodiments, thermal regulation of the reaction mixture may include one or more thermal cycles. For example, electro-magnetic radiation may be applied to the reaction mixture in one or more cycles such that the electro-magnetic radiation is applied and then ceased. In some embodiments, thermally cycling in this way may be performed as appropriate to amplify a template nucleic acid. Amplification of a template nucleic acid may require binding or annealing of amplification oligomers to the template nucleic acid. Appropriate temperature conditions may, in some cases, be such that each thermal cycle is performed at a desired annealing temperature. A desired annealing temperature may be sufficient for annealing of an amplification oligomers or primers to a nucleic acid target.

In embodiments, thermal cycling using an electro-magnetic radiation source allows primer extension reactions to occur to generate amplified product. Primer extension reactions generally include a cycle of incubating a reaction mixture at a denaturation temperature for a denaturation duration and incubating a reaction mixture at an elongation temperature for an elongation duration. In any of the various aspects, multiple cycles of a primer extension reaction can be conducted through monitoring the amount of electro-magnetic radiation applied to the reaction mixture. Any suitable number of cycles may be conducted. For example, the number of cycles conducted may be between about 5 cycles to about 100 cycles. The number of cycles conducted may depend upon, for example, the number of cycles (e.g., cycle threshold value (Ct)) used to obtain a detectable amplified product (e.g., a detectable amount of amplified DNA product that is indicative of the presence of a target DNA in a nucleic acid sample).

In some embodiments, the chemical synthesis reaction may be performed in a capillary tube that has a radius smaller than the Debye length of the reaction mixture. Hence, the effects of the wavelength screening can be ignored to the first-order.

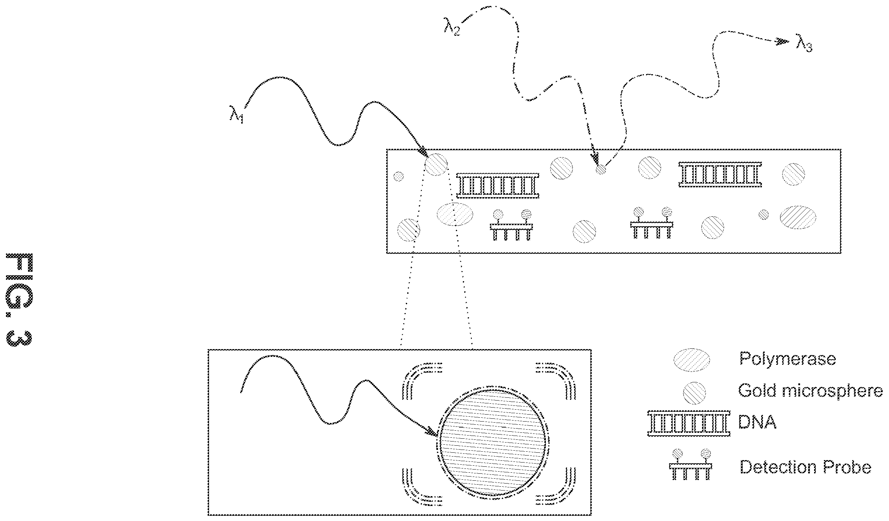

FIG. 3 illustrates by way of example, real-time detection and monitoring of a chemical synthesis reaction in accordance with various embodiments disclosed herein. For example, if the chemical synthesis reaction is nucleic acid amplification, once a reaction mixture containing micro-objects is prepared and electro-magnetic radiation that is wavelength-matched to the plasmon resonance of the micro-object is applied, amplification of the nucleic acid may occur. In some embodiments, the nucleic acid amplification may be continuously monitored in real-time. Monitoring the chemical synthesis reaction in real-time may include measuring a background illumination of the electro-magnetic radiation using P/N photodiodes matched to the electro-magnetic radiation source. In some embodiments, monitoring the chemical synthesis reaction in real-time may include using a fluorescent signal generated from a detection probe in the reaction mixture. For example, the detection probe may be configured to anneal to a specific region of nucleic acids in the reaction mixture and when that region is amplified, the probe creates a signal that may be observed. The detection probe may include a molecular beacon, a molecular torch, and/or a detectable label. In some embodiments, a detectable label may include a chemiluminescent label or a fluorescent label. In some embodiments the detection probe may include a quencher. In some embodiments, the detection probe may include a commercially available detection probe including, for example, a TaqMan® probe. For example, an detection probe (e.g., a TaqMan® probe) may generate a signal following hybridization of the oligonucleotide probe to a nucleic acid and subsequent degradation by a polymerase (e.g., during amplification, such as PCR amplification). An oligonucleotide probe may be degraded by the exonuclease activity of a nucleic acid enzyme. It is to be understood that more than one detection probe may be in the reaction mixture. Moreover, it is to be appreciated that the detection probes of a given reaction mixture may have different targets.

In some embodiments, amplification of the nucleic acid in the reaction mixture results in the generation of a first signal from the first group of detection probes and a second signal from a second group of detection probes. In some embodiments, the first and second signal each may each include cumulative signal measurements generated from the total number of amplified reaction volumes containing an amplicon from each of the first and second pluralities of nucleic acids. In some embodiments, the first and second signals each may include cumulative signal measurements generated from each of the first and second pluralities of nucleic acids, wherein the reaction volumes are not quantified. In some embodiments, the signals from the respective detection probes may be used to determine a ratio. In embodiments, a ratio may include a first value derived from the first signal to a second value derived from the second signal. In some embodiments, the ratio may include a first value from the first signal to a second value from the second signal, wherein the values from the respective signals do not include a quantified sum generated from the total number of amplified reaction volumes.

In embodiments, the first signal may be generated in a single fluorescent channel. In some embodiments, the first signal may be generated in more than one fluorescent channel. In some embodiments, the second signal may be generated in a single fluorescent channel. In some embodiments, the second signal may be generated in more than one fluorescent channel. In some embodiments, the first and second signal may be generated in a single fluorescent channel. In some embodiments, the first and second signal may be generated in more than one fluorescent channels.

In embodiments where a detection probe is used, real-time synthesis may be observed by monitoring the signal generated by the probe in the reaction mixture. For example, the signal generated by the fluorogenic TaqMan® detection probe can be monitored by using fast-response LEDs and photodiodes matched to the fluorescent response of the detection probes. Indeed, by choosing the fluorogenic probe carefully, the infrared pump can be simultaneously operated with the fluorescent measurement. In such an example, it is possible to observe the evolution of the fluorescence signal at a rate greater than that of the polymerase enzyme.

The methods and systems described herein may be used to amplify a nucleic acid target. In embodiments, a nucleic acid target may be derived from a biological sample. A biological sample may be a sample derived from a subject. A biological sample may include any number of macromolecules, for example, cellular macromolecules. A biological sample may be derived from another sample. A biological sample may be a tissue sample, such as a biopsy, core biopsy, needle aspirate, or fine needle aspirate. A biological sample may be a fluid sample, such as a blood sample, urine sample, or saliva sample. A biological sample may be a skin sample. A biological sample may be a cheek swab. A biological sample may be a plasma or serum sample. A biological sample may include one or more cells. A biological sample may be, for example, blood, plasma, serum, urine, saliva, mucosal excretions, sputum, stool or tears.

In some embodiments, a nucleic acid target may be derived from one or more cells. A nucleic acid target may include deoxyribonucleic acid (DNA). DNA may be any kind of DNA, including genomic DNA. A nucleic acid target may be viral DNA. A nucleic acid target may include ribonucleic acid (RNA). RNA may be any kind of RNA, including messenger RNA, transfer RNA, ribosomal RNA, and microRNA. RNA may be viral RNA.

In embodiments, nucleic acid targets may include one or more members. A member may be any region of a nucleic acid target. A member may be of any length. A member may be, for example, up to about 1 to about 100000 nucleotides, or more. In some instances, a member may be a gene. A nucleic acid target may include a gene whose detection may be useful in diagnosing one or more diseases. A gene may be a viral gene or bacterial gene whose detection may be useful in identifying the presence or absence of a pathogen in a subject. In some cases, the methods of the present disclosure are useful in detecting the presence or absence or one or more infectious agents (e.g., viruses, bacteria, fungi) in a subject. The nucleic acid targets may be a human gene. In some cases, the methods of the present disclosure are useful in identifying or detecting genetic abnormalities from a subject, for example, fetal aneuploidy (e.g., trisomy 21, trisomy 18, etc.).

In embodiments, a nucleic acid target may be cell-free nucleic acid. Cell-free nucleic acid may be, for example, cell-free tumor DNA, cell-free fetal DNA, cell-free RNA, etc. In some cases, a nucleic acid derived from a cell-free sample may be derived from plasma of a subject. For example, nucleic acid (e.g., maternal nucleic acid and fetal nucleic acid) may be derived from a plasma sample of a pregnant female. A nucleic acid may be a fetal nucleic acid. A nucleic acid may be a maternal nucleic acid. A nucleic acid sequence may correspond to a region of a nucleic acid potentially associated with an aneuploidy (e.g., a nucleic acid sequence of a fetal nucleic acid may be associated with a fetal aneuploidy). In some cases, the methods of the present disclosure are useful in identifying and estimating a fetal fraction in a sample. In some cases, the methods of the present disclosure are useful in identifying the presence or absence of a fetal aneuploidy in a sample. In some cases, the methods of the present disclosure are useful in detecting the relative amount of a fetal nucleic acid in a cell-free nucleic acid sample from a subject, thereby diagnosing the fetus for one or more genetic abnormalities (e.g., fetal aneuploidy).

In some aspects, one or more nucleic acid molecules analyzed by methods of the present disclosure may correspond to a chromosome. A nucleic acid sequence may be a region of a chromosome associated with a fetal aneuploidy. Chromosomes associated with fetal aneuploidy may include, for example, chromosome 21 (e.g., associated with trisomy 21), chromosome 18 *(e.g.,* associated with trisomy 18), chromosome 13 *(e.g.,* associated with trisomy 13), and an X chromosome (e.g., associated with sex chromosome aneuploidies).

In some embodiments, the nucleic acid target may be a region of the human genome that indicates a predisposition for a particular disease. Markers for a predisposition for a particular disease may be detected by specific mutations or SNPs that are associated with higher infections. For example, a particular mutation or SNP of in a subject may be associated with an increased risk of infection of a particular pathogen. The detection of both a pathogenic nucleic acid sequence and the presence of a SNP in the subject's genome may indicate the subject is at a high risk.

Nucleic acid targets may be of various concentrations in the reaction. The nucleic acid sample may be diluted or concentrated to achieve different concentrations of nucleic acids. The concentration of the nucleic acids in the nucleic acid sample may include between 0.1 nanograms per microliter (ng/$\mu$L) to about 10000 ng/$\mu$L.

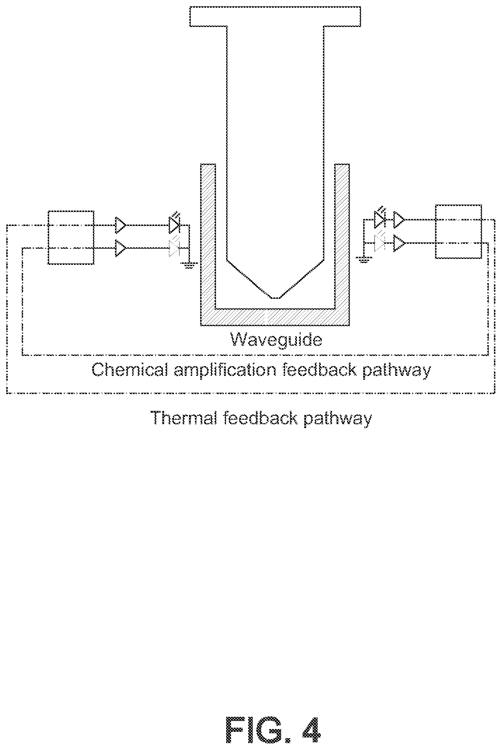

FIG. 4 illustrates an example system for regulating and monitoring a chemical synthesis reaction in accordance with various embodiments disclosed herein. For example, in some embodiments, a system for regulating and monitoring a chemical synthesis reaction may include one or more electro-magnetic radiation sources or other semiconductor devices configured to apply electro-magnetic radiation to the reaction mixture. In some embodiments, the electro-magnetic radiation source may include a laser diode. In embodiments, the system may include a receiving unit that houses a reaction mixture. In some embodiments, the reaction mixture may include one or more micro-objects. In embodiments, the micro-objects within the reaction mixture may be distributed uniformly throughout the reaction mixture. A system may also include one or more feedback monitoring photodiodes or photo-transducers. The synchronized firing and measurement of the electro-magnetic radiation source and its feedback monitoring photodiodes can be used to continuously drive and regulate a chemical synthesis reaction. In some embodiments, the thermal profile of the reaction is controlled by flickering an laser diode that is wavelength-matched to the plasmon resonance of the micro-objects. The decay in the plasmon resonance of these molecules may be used to modulate the temperature of the reaction. In some embodiments, a system for regulating and monitoring a chemical synthesis reaction may include one or more waveguides, controllers, and/or receivers. In some embodiments, system may also include a computer component programmed to apply, with an electro-magnetic radiation source, electro-magnetic radiation to the reaction mixture. For example, the computer component may be programmed to apply electro-magnetic radiation to the reaction mixture using an electro-magnetic radiation source. In some embodiments, the computer component may also monitor the chemical synthesis reaction through analyzing the input from the feedback monitoring photodiodes. In some embodiments, the computer component may also modulate the temperature of the reaction based on input from the feedback monitoring photodiodes.

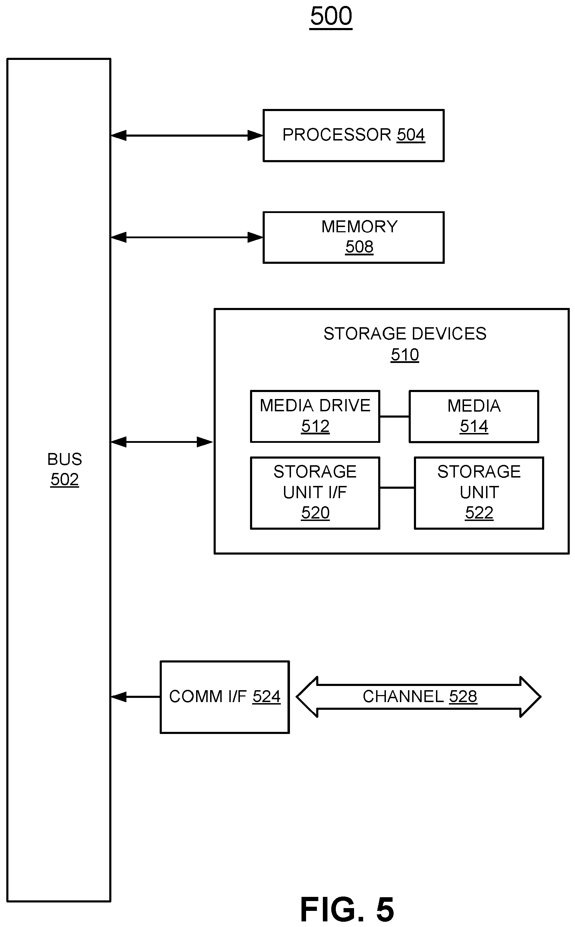

FIG. 5 illustrates example computing component 500. Computing component 500 may be used to implement various features and/or functionality of embodiments of the methods and systems disclosed herein. With regard to the above-described embodiments set forth herein in the context of methods and systems described with reference to FIGS. 1 through 4, one of skill in the art will appreciate additional variations and details regarding the functionality of these embodiments that may be carried out by computing component 500. In this connection, it will also be appreciated by one of skill in the art upon studying the present disclosure that features and aspects of the various embodiments (e.g., systems) described herein may be implemented with respected to other embodiments (e.g., methods) described herein without departing from the spirit of the disclosure.

As used herein, the term component may describe a given unit of functionality that may be performed in accordance with one or more embodiments of the present application. As used herein, a component references a module, and/or may be implemented utilizing any form of hardware, software, or a combination thereof. For example, one or more processors, controllers, ASICs, PLAs, PALs, CPLDs, FPGAs, logical components, software routines or other mechanisms may be implemented to make up a component. In embodiment, the various components described herein may be implemented as discrete components or the functions and features described may be shared in part or in total among one or more components. In other words, as would be apparent to one of ordinary skill in the art after reading this description, the various features and functionality described herein may be implemented in any given application and may be implemented in one or more separate or shared components in various combinations and permutations. Even though various features or elements of functionality may be individually described or claimed as separate components, one of ordinary skill in the art will understand upon studying the present disclosure that these features and functionality may be shared among one or more common software and hardware elements, and such description shall not require or imply that separate hardware or software components are used to implement such features or functionality.

Where components of the application are implemented in whole or in part using software, in one embodiment, these software elements can be implemented to operate with a computing or processing component capable of carrying out the functionality described with respect thereto. One such example computing component is shown in FIG. 5. Various embodiments are described in terms of this example-computing component 500. After reading this description, it will become apparent to a person skilled in the relevant art how to implement the application using other computing components or architectures.

Referring now to FIG. 5, computing component 500 may represent, for example, computing or processing capabilities found within a self-adjusting display, desktop, laptop, notebook, and tablet computers; hand-held computing devices (tablets, PDA's, smart phones, cell phones, palmtops, etc.); workstations or other devices with displays; servers; or any other type of special-purpose or general-purpose computing devices as may be desirable or appropriate for a given application or environment. Computing component 500 might also represent computing capabilities embedded within or otherwise available to a given device. For example, a computing component might be found in other electronic devices such as, for example navigation systems, portable computing devices, and other electronic devices that might include some form of processing capability.

Computing component 500 might include, for example, one or more processors, controllers, control components, or other processing devices, such as a processor 504. Processor 504 might be implemented using a general-purpose or special-purpose processing engine such as, for example, a microprocessor, controller, or other control logic. In the illustrated example, processor 504 is connected to a bus 502, although any communication medium can be used to facilitate interaction with other components of computing component 500 or to communicate externally.

Computing component 500 might also include one or more memory components, simply referred to herein as main memory 508. For example, preferably random access memory (RAM) or other static or dynamic memory, might be used for storing information and instructions to be executed by processor 504. Main memory 508 might also be used for storing temporary variables or other intermediate information during execution of instructions to be executed by processor 504. Computing component 500 might likewise include a read only memory ("ROM") or other static storage device coupled to bus 502 for storing static information and instructions for processor 504.

The computing component 500 might also include one or more various forms of information storage mechanism 510, which might include, for example, a media drive 512 and a storage unit interface 520. The media drive 512 might include a drive or other mechanism to support fixed or removable storage media 514. For example, a hard disk drive, a solid state drive, a magnetic tape drive, an optical disk drive, a compact disc (CD) or digital video disc (DVD) drive (R or RW), or other removable or fixed media drive might be provided. Accordingly, storage media 514 might include, for example, a hard disk, flash drive, an integrated circuit assembly, USB, magnetic tape, cartridge, optical disk, a CD or DVD, or other fixed or removable medium that is read by, written to or accessed by media drive 512. As these examples illustrate, the storage media 514 can include a computer usable storage medium having stored therein computer software or data.

In alternative embodiments, information storage mechanism 510 might include other similar instrumentalities for allowing computer programs or other instructions or data to be loaded into computing component 500. Such instrumentalities might include, for example, a fixed or removable storage unit 522 and an interface 520. Examples of such storage units 522 and interfaces 520 can include a program cartridge and cartridge interface, a removable memory (for example, a flash memory or other removable memory component) and memory slot, a PCMCIA slot and card, and other fixed or removable storage units 522 and interfaces 520 that allow software and data to be transferred from the storage unit 522 to computing component 500.

Computing component 500 might also include a communications interface 524. Communications interface 524 might be used to allow software and data to be transferred between computing component 500 and external devices. Examples of communications interface 524 might include a modem or softmodem, a network interface (such as an Ethernet, network interface card, WiMedia, IEEE 802.XX or other interface), a communications port (such as for example, a USB port, IR port, RS232 port Bluetooth® interface, or other port), or other communications interface. Software and data transferred via communications interface 524 might typically be carried on signals, which can be electronic, electromagnetic (which includes optical) or other signals capable of being exchanged by a given communications interface 524. These signals might be provided to communications interface 524 via a channel 528. This channel 528 might carry signals and might be implemented using a wired or wireless communication medium. Some examples of a channel might include a phone line, a cellular link, an RF link, an optical link, a network interface, a local or wide area network, and other wired or wireless communications channels.

In this document, the terms "computer program medium" and "computer usable medium" are used to generally refer to transitory or non-transitory media such as, for example, memory 508, storage unit 520, media 514, and channel 528. These and other various forms of computer program media or computer usable media may be involved in carrying one or more sequences of one or more instructions to a processing device for execution. Such instructions embodied on the medium, are generally referred to as "computer program code" or a "computer program product" (which may be grouped in the form of computer programs or other groupings). When executed, such instructions might enable the computing component 500 to perform features or functions of the present application as discussed herein.

The various methods and systems disclosed herein may be implemented through use of a kit. In embodiments, a kit for regulating a chemical synthesis reaction may include an electro-magnetic radiation source, including, for example, an infrared laser diode. In some embodiments, the kit may include more than one infrared laser diodes. In some embodiments, the kit may include micro-objects. In some embodiments, the kit may include more than one micro-objects. For example, in some aspects, the kit may include one or more gold microspheres. In some embodiments, the kit may also include a set of amplification oligomers configured to amplify a plurality of nucleic acids, including for example, a first plurality of nucleic acids and a second plurality of nucleic acids. In some embodiments, the amplification oligomers may include a forward amplification oligomer and a reverse amplification oligomer. The kit may also include detection probes configured to anneal to nucleic acids, wherein each of the detection probes includes a fluorescent label. In some embodiments, the detection probes may be configured to anneal to a first plurality of nucleic acids and a second group of detection probes may be configured to anneal to a second plurality of nucleic acids. In some embodiments, the kit may also include one or more deoxyribonucleotide triphosphates. In some embodiments, the kit may also include one or more thermostable polymerases. In some embodiments, the kit may also include one or more capillary tubes. The kit may also include one or more reagents and/or buffers.

The term "about" when referring to a measurable value such as an amount, a temporal duration, and the like, is meant to encompass variations of ±20% or in some instances ±10%, or in some instances ±5%, or in some instances ±1%, or in some instances ±0.1% from the specified value, as such variations are appropriate to perform the disclosed methods. Further, "about" can mean plus or minus less than 1 or 1, 2, 3, 4, 5, 6, 7, 8, 9, 10, 11, 12, 13, 14, 15, 16, 17, 18, 19, 20, 25, 30, or greater than 30 percent, depending upon the situation and known or knowable by one skilled in the art. About also includes the exact amount. Hence "about 200 nM" means "about 200 nM" and also "200 nM".

While preferred embodiments of the present invention have been shown and described herein, it will be obvious to those skilled in the art that such embodiments are provided by way of example only. It is not intended that the invention be limited by the specific examples provided within the specification. While the invention has been described with reference to the aforementioned specification, the descriptions and illustrations of the embodiments herein are not meant to be construed in a limiting sense. Numerous variations, changes, and substitutions will now occur to those skilled in the art without departing from the invention. Furthermore, it shall be understood that all aspects of the invention are not limited to the specific depictions, configurations or relative proportions set forth herein which depend upon a variety of conditions and variables. It should be understood that various alternatives to the embodiments of the invention described herein may be employed in practicing the invention. It is therefore contemplated that the invention shall also cover any such alternatives, modifications, variations or equivalents. It is intended that the following claims define the scope of the invention and that methods and structures within the scope of these claims and their equivalents be covered thereby.

It is understood that the present invention is not limited to the specific details of these examples.

Accordingly, it is not desired that the invention should be limited to the exact structure shown and described in the examples provided. As used herein, the singular forms "a," "an," and "the" are intended to include the plural forms as well, unless the context clearly indicates otherwise. Furthermore, to the extent that the terms "including," "includes," "having," "has," "with," "such as," or variants thereof, are used in either the specification and/or the claims, such terms are not limiting and are intended to be inclusive in a manner.

Where values are described as ranges, it will be understood that such disclosure includes the disclosure of all possible sub-ranges within such ranges, as well as specific numerical values that fall within such ranges irrespective of whether a specific numerical value or specific sub-range is expressly stated.

**Claims**

1. A method for regulating a chemical synthesis reaction, the method comprising:

   introducing a metal micro-object having a diameter between 100 nm to 10 $\mu$m to a reaction mixture;
   determining a plasmon resonance of the metal micro-object based on a characteristic of the metal micro-object; and
   applying, with an electro-magnetic radiation source, electro-magnetic radiation to the reaction mixture;
   wherein the electro-magnetic radiation is wavelength-matched to the plasmon resonance of the metal micro-object;
   such that application of the electro-magnetic radiation to the metal micro-object excites atoms within the metal micro-object, causing those atoms to release energy in the form of phonons within the reaction mixture thereby increasing an average kinetic energy of the reaction mixture; and further comprising measuring a background illumination using a photodiode matched to the electro-magnetic radiation source.

2. The method of claim 1, wherein the characteristic of the metal micro-object comprises one or more of a shape, a metal, and a permittivity.

3. The method of claim 2, wherein the shape of the metal micro-object comprises a sphere, a rod, a cylinder, or a cube; or wherein the electro-magnetic radiation is infrared radiation.

4. The method of claim 1, wherein the metal micro-object comprises gold, silver, titanium, nickel, steel, tin, platinum, copper, aluminum, lead, or iron.

5. The method of claim 1, wherein the reaction mixture further comprises one or more of buffers, reagents, a thermostable polymerase, and deoxyribonucleotide triphosphates.

6. A method for regulating a chemical synthesis reaction, according to claim 1, the method comprising:

   introducing a metal micro-object, as defined in claim 1, to a reaction mixture;
   determining a plasmon resonance of the metal micro-object based on a characteristic of the metal micro-object; and
   applying, with an electro-magnetic radiation source, electro-magnetic radiation to the reaction mixture;

   wherein the reaction mixture comprises:

   a biological sample;
   amplification oligomers;
   deoxyribonucleotide triphosphates; and
   a thermostable polymerase;
   wherein the electro-magnetic radiation is wavelength-matched to the plasmon resonance of the metal micro-object;

   such that application of the electro-magnetic radiation to the metal micro-object excites atoms within the metal micro-object, causing those atoms to release energy in the form of phonons within the reaction mixture thereby increasing an average kinetic energy of the reaction mixture; and further comprising measuring a background illumination using a photodiode matched to the electro-magnetic radiation source.

7. The method of claim 6, wherein the characteristic of the metal micro-object comprises one or more of a shape, a metal, and a permittivity; or wherein the shape of the metal micro-object comprises a sphere, a rod, a cylinder, or a cube.

8. The method of claim 6, wherein the biological sample comprises genomic DNA.

9. The method of claim 6, wherein the reaction mixture further comprises a detection probe.

10. The method of claim 9, wherein the detection probe comprises a fluorescent label.

11. A system for regulating a chemical synthesis reaction, the system comprising:
    an electro-magnetic radiation source;
    a receiving unit containing a reaction mixture comprising a metal micro-object, as defined in claim 1; and

a computer component programed to apply, with the electro-magnetic radiation source, electro-magnetic radiation to the reaction mixture;

wherein the electro-magnetic radiation is wavelength-matched to the plasmon resonance of the metal micro-object;

such that application of the electro-magnetic radiation to the metal micro-object excites atoms within the metal micro-object, causing those atoms to release energy in the form of phonons within the reaction mixture thereby increasing an average kinetic energy of the reaction mixture; and further configured for measuring a background illumination using a photodiode matched to the electro-magnetic radiation source.

12. The system of claim 11, wherein the metal micro-object comprises gold, silver, titanium, nickel, steel, tin, platinum, copper, aluminum, lead, or iron.

**Patentansprüche**

1. Verfahren zum Regulieren einer chemischen Synthesereaktion, wobei das Verfahren Folgendes umfasst:

Einführen eines Metallmikroobjekts mit einem Durchmesser zwischen 100 nm und 10 μm zu einem Reaktionsgemisch;
Bestimmen einer Plasmonenresonanz des Metallmikroobjekts basierend auf einer Eigenschaft des Metallmikroobjekts; und
Aufbringen, mit einer elektromagnetischen Strahlungsquelle, von elektromagnetischer Strahlung auf das Reaktionsgemisch;
wobei die Wellenlänge der elektromagnetischen Strahlung auf die Plasmonenresonanz des Metallmikroobjekts abgestimmt ist;
sodass das Aufbringen der elektromagnetischen Strahlung auf das Metallmikroobjekt Atome innerhalb des Metallmikroobjekts anregt, was bewirkt, dass diese Atome Energie in Form von Phononen innerhalb des Reaktionsgemisches freisetzen, wodurch eine durchschnittliche kinetische Energie des Reaktionsgemisches erhöht wird; und ferner umfassend Messen einer Hintergrundbeleuchtung unter Verwendung einer Photodiode, die mit der elektromagnetischen Strahlungsquelle übereinstimmt.

2. Verfahren nach Anspruch 1, wobei die Eigenschaft des Metallmikroobjekts eines oder mehrere von einer Form, einem Metall und einer Permittivität umfasst.

3. Verfahren nach Anspruch 2, wobei die Form des Metallmikroobjekts eine Kugel, einen Stab, einen Zylinder oder einen Würfel umfasst; oder wobei die elektromagnetische Strahlung Infrarotstrahlung ist.

4. Verfahren nach Anspruch 1, wobei das Metallmikroobjekt Gold, Silber, Titan, Nickel, Stahl, Zinn, Platin, Kupfer, Aluminium, Blei oder Eisen umfasst.

5. Verfahren nach Anspruch 1, wobei das Reaktionsgemisch ferner eines oder mehrere von Puffern, Reagenzien, einer thermostabilen Polymerase und Desoxyribonukleotid-Triphosphaten umfasst.

6. Verfahren zum Regulieren einer chemischen Synthesereaktion nach Anspruch 1, wobei das Verfahren Folgendes umfasst:

Einführen eines Metallmikroobjekts nach Anspruch 1 in ein Reaktionsgemisch;
Bestimmen einer Plasmonenresonanz des Metallmikroobjekts basierend auf einer Eigenschaft des Metallmikroobjekts; und
Aufbringen, mit einer elektromagnetischen Strahlungsquelle, von elektromagnetischer Strahlung auf das Reaktionsgemisch;
wobei das Reaktionsgemisch Folgendes umfasst:

eine biologische Probe;
Amplifikationsoligomere;
Desoxyribonukleotid-Triphosphate; und
eine thermostabile Polymerase;
wobei die Wellenlänge der elektromagnetischen Strahlung auf die Plasmonenresonanz des Metallmikroobjekts abgestimmt ist;
sodass das Aufbringen der elektromagnetischen Strahlung auf das Metallmikroobjekt Atome innerhalb des Metallmikroobjekts anregt, was bewirkt, dass diese Atome Energie in Form von Phononen innerhalb des Reaktionsgemisches freisetzen, wodurch eine durchschnittliche kinetische Energie des Reaktionsgemisches erhöht wird; und ferner umfassend Messen einer Hintergrundbeleuchtung unter Verwendung einer Photodiode, die mit der elektromagnetischen Strahlungsquelle übereinstimmt.

7. Verfahren nach Anspruch 6, wobei die Eigenschaft des Metallmikroobjekts eines oder mehrere von einer Form, einem Metall und einer Permittivität umfasst; oder wobei die Form des Metallmikroobjekts eine Kugel, einen Stab, einen Zylinder oder einen Würfel umfasst.

**8.** Verfahren nach Anspruch 6, wobei die biologische Probe genomische DNA umfasst.

**9.** Verfahren nach Anspruch 6, wobei das Reaktionsgemisch ferner eine Nachweissonde umfasst.

**10.** Verfahren nach Anspruch 9, wobei die Nachweissonde eine fluoreszierende Markierung umfasst.

**11.** System zum Regulieren einer chemischen Synthesereaktion, wobei das System Folgendes umfasst:

eine elektromagnetische Strahlungsquelle;
eine Aufnahmeeinheit, die ein Reaktionsgemisch enthält, das ein Metallmikroobjekt nach Anspruch 1 umfasst; und
eine Computerkomponente, die dazu programmiert ist, elektromagnetische Strahlung mit der elektromagnetischen Strahlungsquelle auf das Reaktionsgemisch aufzubringen;
wobei die Wellenlänge der elektromagnetischen Strahlung auf die Plasmonenresonanz des Metallmikroobjekts abgestimmt ist;
sodass das Aufbringen der elektromagnetischen Strahlung auf das Metallmikroobjekt Atome innerhalb des Metallmikroobjekts anregt, was bewirkt, dass diese Atome Energie in Form von Phononen innerhalb des Reaktionsgemisches freisetzen, wodurch eine durchschnittliche kinetische Energie des Reaktionsgemisches erhöht wird; und konfiguriert zum Messen einer Hintergrundbeleuchtung unter Verwendung einer Photodiode, die mit der elektromagnetischen Strahlungsquelle übereinstimmt.

**12.** System nach Anspruch 11, wobei das Metallmikroobjekt Gold, Silber, Titan, Nickel, Stahl, Zinn, Platin, Kupfer, Aluminium, Blei oder Eisen umfasst.

## Revendications

**1.** Procédé de régulation d'une réaction de synthèse chimique, le procédé comprenant :

l'introduction d'un micro-objet métallique ayant un diamètre compris entre 100 nm et 10 $\mu$m dans un mélange réactionnel ;
la détermination d'une résonance plasmonique du micro-objet métallique sur la base d'une caractéristique du micro-objet métallique ; et
l'application, avec une source de rayonnement électromagnétique, d'un rayonnement électromagnétique au mélange réactionnel ;
dans lequel le rayonnement électromagnétique est adapté en longueur d'onde à la résonance plasmonique du micro-objet métallique ;
de telle sorte que l'application du rayonnement électromagnétique au micro-objet métallique excite les atomes à l'intérieur du micro-objet métallique, amenant ces atomes à libérer de l'énergie sous forme de phonons dans le mélange réactionnel, augmentant ainsi l'énergie cinétique moyenne du mélange réactionnel ; et en outre
comprenant la mesure d'un éclairage de fond à l'aide d'une photodiode adaptée à la source de rayonnement électromagnétique.

**2.** Procédé selon la revendication 1, dans lequel la caractéristique du micro-objet métallique comprend un ou plusieurs parmi une forme, un métal et une permittivité.

**3.** Procédé selon la revendication 2, dans lequel la forme du micro-objet métallique comprend une sphère, une tige, un cylindre ou un cube ; ou dans lequel le rayonnement électromagnétique est un rayonnement infrarouge.

**4.** Procédé selon la revendication 1, dans lequel le micro-objet métallique comprend de l'or, de l'argent, du titane, du nickel, de l'acier, de l'étain, du platine, du cuivre, de l'aluminium, du plomb ou du fer.

**5.** Procédé selon la revendication 1, dans lequel le mélange réactionnel comprend en outre un ou plusieurs parmi des tampons, des réactifs, une polymérase thermostable et des désoxyribonucléotides triphosphates.

**6.** Procédé de régulation d'une réaction de synthèse chimique, selon la revendication 1, le procédé comprenant :

l'introduction d'un micro-objet métallique, tel que défini dans la revendication 1, dans un mélange réactionnel ;
la détermination d'une résonance plasmonique du micro-objet métallique sur la base d'une caractéristique du micro-objet métallique ; et
l'application, avec une source de rayonnement électromagnétique, d'un rayonnement électromagnétique au mélange réactionnel ;
dans lequel le mélange réactionnel comprend :

un échantillon biologique ;
des oligomères d'amplification ;
des désoxyribonucléotides triphosphates ; et
une polymérase thermostable ;
dans lequel le rayonnement électromagnétique est adapté en longueur d'onde à la résonance plasmonique du micro-objet métallique ;
de telle sorte que l'application du rayonnement électromagnétique au micro-objet métallique excite les atomes à l'intérieur du micro-objet métallique, amenant ces atomes à libérer de l'énergie sous forme de phonons dans le mélange réactionnel, augmentant ainsi l'énergie cinétique moyenne du mélange réactionnel ; et en outre

comprenant la mesure d'un éclairage de fond à l'aide d'une photodiode adaptée à la source de rayonnement électromagnétique.

7. Procédé selon la revendication 6, dans lequel la caractéristique du micro-objet métallique comprend un ou plusieurs parmi une forme, un métal et une permittivité ; ou dans lequel la forme du micro-objet métallique comprend une sphère, une tige, un cylindre ou un cube.

8. Procédé selon la revendication 6, dans lequel l'échantillon biologique comprend de l'ADN génomique.

9. Procédé selon la revendication 6, dans lequel le mélange réactionnel comprend en outre une sonde de détection.

10. Procédé selon la revendication 9, dans lequel la sonde de détection comprend un marqueur fluorescent.

11. Système de régulation d'une réaction de synthèse chimique, le système comprenant :

une source de rayonnement électromagnétique ;
une unité de réception contenant un mélange réactionnel comprenant un micro-objet métallique, tel que défini dans la revendication 1 ; et
un composant informatique programmé pour appliquer, avec la source de rayonnement électromagnétique, un rayonnement électromagnétique au mélange réactionnel ;
dans lequel le rayonnement électromagnétique est adapté en longueur d'onde à la résonance plasmonique du micro-objet métallique ;
de telle sorte que l'application du rayonnement électromagnétique au micro-objet métallique excite les atomes à l'intérieur du micro-objet métallique, amenant ces atomes à libérer de l'énergie sous forme de phonons dans le mélange réactionnel, augmentant ainsi l'énergie cinétique moyenne du mélange réactionnel ; et en outre
configuré pour mesurer un éclairage d'arrière-plan à l'aide d'une photodiode adaptée à la source de rayonnement électromagnétique.

12. Système selon la revendication 11, dans lequel le micro-objet métallique comprend de l'or, de l'argent, du titane, du nickel, de l'acier, de l'étain, du platine, du cuivre, de l'aluminium, du plomb ou du fer.

<u>100</u>

<u>110</u>

Introduce Metal Micro-Object To Reaction Mixture

<u>120</u>

Determine Plasmon Resonance Of The Metal Micro-Object

<u>130</u>

Apply Electro-Magnetic Radiation To Reaction Mixture

# FIG. 1

FIG. 2

FIG. 3

Waveguide

Chemical amplification feedback pathway

Thermal feedback pathway

FIG. 4

## 500

**FIG. 5**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2005202185 A1
- US 2009294692 A